# EUROPÄISCHE PATENTSCHRIFT

(11) **EP 3 366 093 B1**
(45) Veröffentlichungstag und Bekanntmachung des Hinweises auf die Patenterteilung: **16.09.2020**
(21) Anmeldenummer: 15825604.0
(22) Anmeldetag: 22.12.2015
(51) Int. Cl.: H05K 7/14, H01L 25/07

(54) **ELEKTRISCHES MODUL MIT ELEKTRISCHER KOMPONENTE**
ELECTRICAL MODULE HAVING AN ELECTRICAL COMPONENT
MODULE ÉLECTRIQUE AVEC COMPOSANTS ÉLECTRIQUES

(43) Veröffentlichungstag der Anmeldung: 29.08.2018
(73) Patentinhaber: Siemens Aktiengesellschaft, 80333 München (DE)
(72) Erfinder: FRENKEL, Stephan, 90431 Nürnberg (DE); PIERSTORF, Steffen, 90443 Nürnberg (DE); SCHMITT, Daniel, 92353 Postbauer-Heng (DE); SCHREMMER, Frank, 90768 Fürth (DE); WAHLE, Marcus, 90587 Veitsbronn (DE)
(86) Internationale Anmeldenummer: PCT/EP2015/081016
(87) Internationale Veröffentlichungsnummer: WO 2017/108104

(56) Entgegenhaltungen:
- EP-A2- 1 778 001
- EP-A2- 2 782 131
- DE-A1-102004 062 880
- JP-A- 2003 332 527
- US-A1- 2010 265 744
- US-A1- 2012 001 317
- US-B1- 6 561 522

## Beschreibung

Die Erfindung bezieht sich auf elektrische Module, die jeweils mit mindestens einer in einem Modulgehäuse untergebrachten elektrischen Komponente ausgestattet sind.

Derartige elektrische Module werden beispielsweise bei elektrischen Umrichtern, insbesondere Multilevelumrichtern, eingesetzt, bei denen eine Vielzahl an elektrischen Modulen der beschriebenen Art sehr dicht nebeneinander angeordnet sind. Die Module sind bei solchen Umrichtern häufig unter Bildung von Modulreihenschaltungen elektrisch in Reihe geschaltet.

Die Druckschrift WO 2012/156261 A2 beschreibt ein Ausführungsbeispiel für einen Multilevelumrichter, bei dem elektrische Module, wie sie hier nachfolgend beschrieben werden, eingesetzt werden können.

Insbesondere im Bereich der Energieübertragungstechnik werden die beschriebenen elektrischen Module mit sehr großen elektrischen Strömen belastet, so dass im Falle eines Ausfalls einer Komponente bzw. einem Fehlerfall aufgrund der umgesetzten elektrischen Leistung eine explosionsartige Zerstörung der im Modulgehäuse befindlichen elektrischen Komponente bzw. Komponenten erfolgen kann; weicht Explosionsgas (z.B. metallischer/kohlenstoffhaltiger Staub, Splitter etc.) aus dem Modulgehäuse aus, können benachbarte elektrische Module, die zuvor noch elektrisch einwandfrei arbeiteten, von dem Explosionsgas beeinträchtigt oder zerstört werden, da dadurch die Luftstrecke aufgrund der Verunreinigungen unterschritten wird, so dass eine Kettenreaktion auftreten kann, durch die eine Vielzahl an benachbarten elektrischen Modulen zerstört wird. Bei den oben beschriebenen Umrichtern kann dies - insbesondere im Hochspannungsbereich - dramatische Folgen haben.

Insbesondere die DE 10 2004 062660 A1 offenbart bereits ein elektrisches Modul mit zumindest einer in einem Modulgehäuse untergebrachten elektrischen Komponente, wobei
- das Modulgehäuse zumindest zwei Gehäuseteile aufweist, die aufeinander liegen und - allein oder gemeinsam mit einem oder mehreren weiteren Gehäuseteilen des Modulgehäuses - den Innenraum des Modulgehäuses begrenzen, und
- zur Abdichtung der Auflagefläche zwischen den beiden Gehäuseteilen mindestens ein Dichtelement vorhanden ist.
Auch aus der EP 1 778 001 A2, JP 2003 332527 A und der EP 2 782 131 A2 ist ein solches elektrisches Modul bekannt.

Der Erfindung liegt die Aufgabe zugrunde, ein elektrisches Modul für einen Umrichter anzugeben, bei dem im Falle eines Fehlers bzw. einer Explosion im Innenraum des Modulgehäuses ein Gasfluss nach außen bzw. ein Austreten von Explosionsgasen nach außen verhindert, zumindest aber besser als bisher gehemmt wird.

Diese Aufgabe wird erfindungsgemäß durch ein elektrisches Modul mit den Merkmalen gemäß Patentanspruch 1 gelöst. Vorteilhafte Ausgestaltungen des erfindungsgemäßen Moduls sind in Unteransprüchen angegeben.

Danach ist erfindungsgemäß vorgesehen, dass die zwei Gehäuseteile jeweils eine Vertiefunq, insbesondere Nut, aufweisen und das Dichtelement mit einem Dichtabschnitt in die Vertiefung in dem einen Gehäuseteil und mit einem anderen Dichtabschnitt in die Vertiefung in dem anderen Gehäuseteil hineinragt, so dass im Falle einer Explosion im Innenraum des Modulgehäuses ein Austreten von Explosionsgasen nach außen durch das Dichtelement gestoppt oder zumindest reduziert wird. Insbesondere wird ein besonders sicherer Sitz der Dichtung und damit eine besonders zuverlässige Abdichtung erreicht.

Ein wesentlicher Vorteil des erfindungsgemäßen Moduls besteht darin, dass durch das erfindungsgemäß vorgesehene mindestens eine Dichtelement eine zusätzliche Abdichtung zwischen den aufeinander liegenden Gehäuseteilen erreicht wird, so dass im Falle eines Fehlers das Austreten von Explosionsgasen dort zumindest gehemmt wird. Die Erfindung trägt dem Umstand Rechnung, dass bei hohem Druck im Innenraum des Modulgehäuses ein gewisses Auseinanderdrücken der aufeinander liegenden Gehäuseteile auftreten kann, auch wenn diese im Normalbetrieb mechanisch ausreichend zusammengehalten werden, weil sie beispielsweise verschraubt sind oder mittels einer Spannvorrichtung zusammengedrückt werden.

Mit Blick auf eine besonders gute Dichtwirkung wird es als vorteilhaft angesehen, wenn das Dichtelement oder zumindest ein Dichtabschnitt des Dichtelements, insbesondere eine Dichtlippe des Dichtelements, sich winklig zu derjenigen Auflageebene erstreckt, in der die zwei Gehäuseteile aufeinander liegen. Durch die winklige Anordnung von Dichtabschnitten relativ zur Auflageebene wird erreicht, dass selbst im Falle einer Spaltbildung zwischen aufeinanderliegenden Modulgehäuseteilen ein Zurückhalten bzw. Aufhalten von Explosionsgasen möglich ist.

Besonders vorteilhaft ist es, wenn zumindest eines der zwei Gehäuseteile eine Vertiefung, insbesondere Nut, aufweist, in die das Dichtelement oder ein Dichtabschnitt hineinragt oder in der sich das Dichtelement oder der Dichtabschnitt befindet. Durch eine Vertiefung oder Nut wird für austretendes Gas eine Gasumlenkung erzwungen, wodurch eine Abkühlung und Druckreduktion sowie eine Reduktion der kinetischen Energie austretender Partikel erreicht wird.

Eine gute Dichtwirkung wird in vorteilhafter Weise erzielt, wenn das Dichtelement mindestens eine Dichtfläche aufweist, die an einem schräg, insbesondere senkrecht, zur Auflageebene erstreckenden Vertiefungswandabschnitt des einen oder anderen der beiden Gehäuseteile oder an schräg, insbesondere senkrecht, zur Auflageebene erstreckenden Vertiefungswandabschnitten beider Gehäuseteile anliegt.

Vorteilhaft ist es, wenn die Vertiefungen übereinanderliegen bzw. - senkrecht zur Auflagefläche zwischen den beiden Gehäuseteilen gesehen - fluchten.

Bei einer anderen, ebenfalls als sehr vorteilhaft angesehenen Form der Abdichtung ist vorgesehen, dass eines der zwei Gehäuseteile eine Vertiefung, insbesondere Nut, aufweist, in die ein Vorsprung des anderen Gehäuseteils, eingreift und in die Vertiefung, zwischen Vertiefungswand und Vorsprung, das Dichtelement eingelegt ist. Durch den Vorsprung wird eine Art Mäanderbildung erreicht, die eine mehrfache Gasumlenkung für austretendes Gas erzwingt, wodurch - wie bereits erwähnt - eine Abkühlung und Druckreduktion sowie eine Reduktion der kinetischen Energie austretender Partikel erreicht wird.

Nuten und darin eingreifende Vorsprünge können im Bereich der Schnittstelle zwischen den beiden Gehäuseteilen auch doppelt oder mehrfach vorgesehen sein, um die Mäanderbildung bzw. den Grad der Gasumlenkung zu vervielfachen.

Im Falle der letztgenannten Abdichtungsvariante mit Vertiefung und korrespondierendem Vorsprung bzw. mit Vertiefungen und korrespondierenden Vorsprüngen ist es mit Blick auf die Ausgestaltung des Dichtelements vorteilhaft, wenn das Dichtelement im Querschnitt u-förmig oder zumindest abschnittsweise u-förmig ist und zwei Seitenwände und eine die beiden Seitenwände verbindende Bodenwand aufweist, jede der beiden Seitenwände jeweils einen Dichtabschnitt bildet, der winklig zur Auflageebene, in der die zwei Gehäuseteile aufeinander liegen, angeordnet ist und die Bodenwand des Dichtelements auf dem, insbesondere parallel zur Auflageebene liegenden, Vertiefungsboden, insbesondere Nutboden, aufliegt.

In Bereichen, in denen keine elektrischen Leitungen zur Kontaktierung des oder der elektrischen Komponenten angeordnet sind, wird es als vorteilhaft angesehen, wenn die Vertiefung ringförmig ist und ringförmig um den Innenraum des Modulgehäuses außen herumläuft, und das Dichtelement durch einen Dichtring gebildet ist, der den Innenraum des Modulgehäuses ringförmig außen abdichtet.

In Bereichen mit aus dem Modulgehäuse herausgeführten Kontakten zur Kontaktierung des oder der elektrischen Komponenten wird es als vorteilhaft angesehen, wenn die Vertiefung halbringförmig oder wegen durchgeführter elektrischer Kontakte nur annähernd halbringförmig ist und um die Hälfte des Innenraums des Modulgehäuses oder nahezu die Hälfte außen herumläuft. Demgemäß ist bei einer solchen Ausführungsform das Dichtelement vorzugsweise ebenfalls halbringförmig oder annähernd halbringförmig.

Bei der letztgenannten Variante ist es besonders vorteilhaft, wenn eines der zwei Gehäuseteile, oder jeweils beide, zwei halbringförmig umlaufende Nuten aufweist, in die jeweils ein halbringförmiges Dichtelement eingelegt ist, ein erstes Dichtelementende des einen Dichtelements einem ersten Dichtelementende des anderen Dichtelements unter Bildung eines ersten Endenpaares gegenüberliegt und ein zweites Dichtelementende des einen Dichtelements einem zweiten Dichtelementende des anderen Dichtelements unter Bildung eines zweiten Endenpaares gegenüberliegt und zwischen den paarweise gegenüber liegenden Dichtelementenden jeweils eine elektrische Kontaktschiene angeordnet ist, die mit der zumindest einen in dem Modulgehäuse untergebrachten elektrischen Komponente elektrisch verbunden ist.

Zur Abdichtung der Kontaktschienen ist es vorteilhaft, wenn unter und über den Kontaktschienen jeweils ein Plattendichtelement aufliegt, das sich in Richtung Innenraum des Modulgehäuses - senkrecht zur Auflageebene - verdickt oder aufweitet.

Alternativ oder zusätzlich kann vorgesehen sein, dass an der Schnittstellenkante zwischen den zwei Gehäuseteilen innenraumseitig ein ringförmig umlaufendes Dichtelement angeordnet ist, das flächig an den beiden Gehäuseteilen anliegt und bei dem sich ein Dichtabschnitt oder eine Dichtfläche winklig, insbesondere rechtwinklig, zur Auflageebene erstreckt und ein anderer Dichtabschnitt oder eine andere Dichtfläche in der Auflageebene liegt.

Vorzugsweise schützt ein vor dem Dichtelement angeordnetes oder in dem Dichtelement integriertes Schutzelement das Dichtelement vor einer Zerstörung durch Partikelbeschuss im Falle eines explosionsartigen Ausfalls der in dem Modulgehäuse untergebrachten elektrischen Komponente. Das Schutzelement besteht aus Stabilitätsgründen vorzugsweise aus Metall, insbesondere Stahl.

Bei einer Ausgestaltungsvariante ist das Dichtelement im Querschnitt L-förmig.

Bezüglich der abzudichtenden Gehäuseteile wird es als vorteilhaft angesehen, wenn eines der zwei Gehäuseteile eine die elektrische Komponente tragende Kühlplatte bildet und das andere der zwei Gehäuseteile ein ringförmiges Rahmenelement ist. Alternativ können beide Gehäuseteile jeweils ringförmige Rahmenelemente bilden.

Mit Blick auf einen Einsatz bei Umrichtern, insbesondere Umrichtern für Hochspannungsanlagen, wird es als vorteilhaft angesehen, wenn das Modulgehäuse folgende Modulgehäuseteile umfasst:
- eine untere Kühlplatte, die eine untere elektrische Komponente, vorzugsweise ein Halbleiterschaltelement, insbesondere ein einen Transistor aufweisendes Halbleiterschaltelement, trägt,
- ein unteres ringförmiges Rahmenelement, das auf der unteren Kühlplatte aufliegt,
- ein mittleres ringförmiges Rahmenelement, das auf dem unteren Rahmenelement aufliegt, wobei zwischen dem unteren und dem mittleren ringförmigen Rahmenelement zumindest zwei Kontaktschienen zur Kontaktierung der unteren elektrischen Komponente aus dem Modulgehäuse herausgeführt sind,
- ein oberes ringförmiges Rahmenelement, das auf dem mittleren ringförmigen Rahmenelement aufliegt, wobei zwischen dem mittleren und dem oberen ringförmigen Rahmenelement zumindest zwei Kontaktschienen zur Kontaktierung einer oberen elektrischen Komponente, vorzugsweise eines Halbleiterschaltelements, insbesondere eines einen Transistor aufweisenden Halbleiterschaltelements, aus dem Modulgehäuse herausgeführt sind, und
- eine obere Kühlplatte, die auf dem oberen ringförmigen Rahmenelement aufliegt und die obere elektrische Komponente trägt.

Mindestens zwei der genannten Modulgehäuseteile, nämlich solche, die unmittelbar aufeinander liegen, sind vorzugsweise mittels mindestens eines Dichtelements abgedichtet.

Die Gehäuseteile bzw. die Modulgehäuseteile sind vorzugsweise miteinander verbunden, beispielsweise verschraubt, oder werden durch eine externe Spannvorrichtung zusammengehalten, insbesondere aufeinander gedrückt.

Die Erfindung wird nachfolgend anhand von Ausführungsbeispielen näher erläutert; dabei zeigen beispielhaft
- Figur 1: zur allgemeinen Erläuterung ein Ausführungsbeispiel für ein elektrisches Modul ohne Dichtelemente,
- Figur 2: einen Ausschnitt des Moduls gemäß Figur 1 in einer vergrößerten Darstellung im Falle einer Explosion im Innenraum des Modulgehäuses,
- Fig. 3-7: ein erstes Ausführungsbeispiel für ein elektrisches Modul mit Dichtelementen,
- Fig. 8-12: ein zweites Ausführungsbeispiel für ein elektrisches Modul mit Dichtelementen,
- Figur 13: ein drittes Ausführungsbeispiel für ein elektrisches Modul mit Dichtelementen und
- Figur 14: einen Abschnitt eines vierten Ausführungsbeispiels für ein elektrisches Modul mit Dichtelementen.

In den Figuren werden der Übersicht halber für identische oder vergleichbare Komponenten stets dieselben Bezugszeichen verwendet.

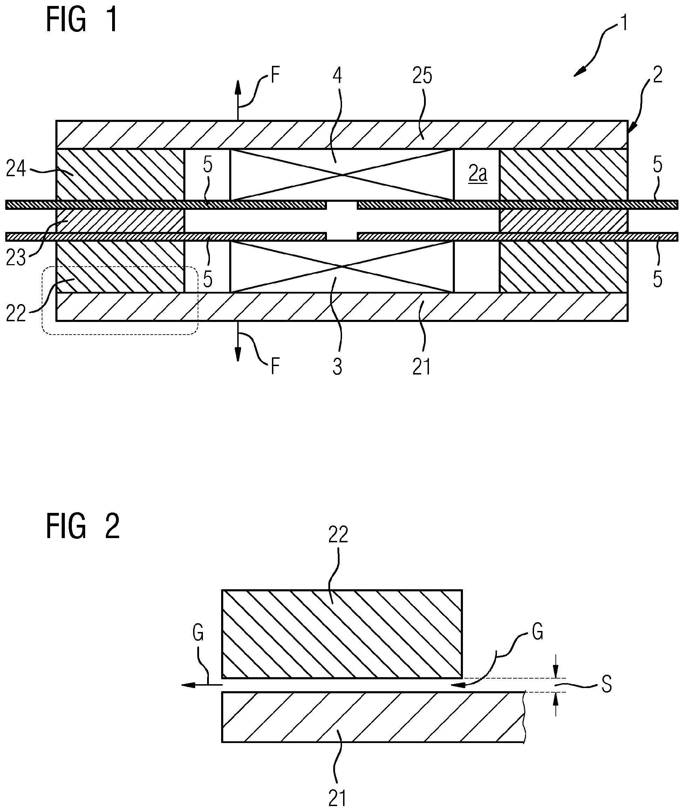

Die Figur 1 zeigt ein elektrisches Modul 1, das ein nach außen verschlossenes Modulgehäuse 2 umfasst. Innerhalb des Modulgehäuses 2 befinden sich ein in der Figur 1 unteres Halbleiterschaltelement 3 und ein in der Figur 1 oberes Halbleiterschaltelement 4. Bei den Halbleiterschaltelementen 3 und 4 handelt es sich beispielsweise um Bipolartransistoren mit isolierter Gateelektrode. Zur Kontaktierung der beiden Halbleiterschaltelemente 3 und 4 sind Kontaktschienen 5 vorhanden, die seitlich aus dem Modulgehäuse 2 herausgeführt sind.

Das Modulgehäuse 2 umfasst zur Kühlung des unteren Halbleiterschaltelements 3 eine in der Figur 1 untere Kühlplatte 21, auf der ein in der Figur 1 unteres ringförmiges Rahmenelement 22 aufliegt. Auf dem unteren ringförmigen Rahmenelement 22 befindet sich ein mittleres ringförmiges Rahmenelement 23, auf dem wiederum ein in der Figur 1 oberes ringförmiges Rahmenelement 24 aufliegt. Nach oben hin wird das Modulgehäuse 2 von einer oberen Kühlplatte 25 abgeschlossen, die auf dem oberen ringförmigen Rahmenelement 24 aufliegt und zur Kühlung des Halbleiterschaltelements 4 dient. Die Kontaktschienen 5 sind zwischen dem mittleren ringförmigen Rahmenelement 23 und dem unteren ringförmigen Rahmenelement 22 bzw. zwischen dem mittleren ringförmigen Rahmenelement 23 und dem oberen ringförmigen Rahmenelement 24 seitlich herausgeführt.

Zum Zusammenhalten der durch die Gehäuseteile des Modulgehäuses 2 gebildeten Sandwichstruktur dienen vorzugsweise Schrauben oder eine externe Spannvorrichtung, die aus Gründen der Übersicht in der Figur 1 nicht weiter gezeigt sind. Beispielsweise können auch mehrere elektrische Module 1 mit ihren Kühlplatten (elektrisch isoliert voneinander) aufeinander liegen; im Falle einer solche Ausführungsform hält die Spannvorrichtung vorzugsweise den Stapel aus Sandwichstrukturen zusammen.

Im Falle eines elektrischen Fehlers und im Falle einer Explosion im Innenraum 2a des Modulgehäuses 2 kann ein sehr hoher Gasdruck entstehen, durch den die Modulgehäuseteile nach außen gedrückt werden; die Kraftwirkung durch den Innendruck im Innenraum 2a ist in der Figur 1 durch Pfeile mit dem Bezugszeichen F gekennzeichnet.

Die Figur 2 zeigt den in der Figur 1 mit gestrichelten Linien markierten Abschnitt des Modulgehäuses 2 in einer vergrößerten Darstellung näher im Detail, wenn im Falle einer Explosion im Innenraum 2a des Modulgehäuses 2 die untere Kühlplatte 21 von dem unteren ringförmigen Rahmenelement 22 - trotz der dagegen wirkenden Haltekraft der Schrauben oder Spannvorrichtung - weggedrückt wird. Es lässt sich erkennen, dass zwischen den zwei Modulgehäuseteilen 21 und 22 ein Spalt S entsteht, durch den ein Gasstrom G aus dem Innenraum 2a entweichen kann. Ein solches Entweichen von heißem Gas nach außen ist unerwünscht, da dieses andere elektrische Module, die in unmittelbarer Nachbarschaft angeordnet sind, ebenfalls zerstören bzw. in Mitleidenschaft ziehen könnte.

Um das Problem eines unerwünschten Gasstromes G nach außen im Falle einer Explosion im Innenraum 2a zu vermeiden, sind bei den nachfolgend beschriebenen Ausführungsbeispielen Dichtelemente vorhanden, die eine Abdichtung des Innenraums 2a des Modulgehäuses 2 ermöglichen. Die Dichtelemente bestehen vorzugsweise aus einem verformbaren bzw. flexiblen, beispielsweise elastischen, Material wie zum Beispiel Gummi.

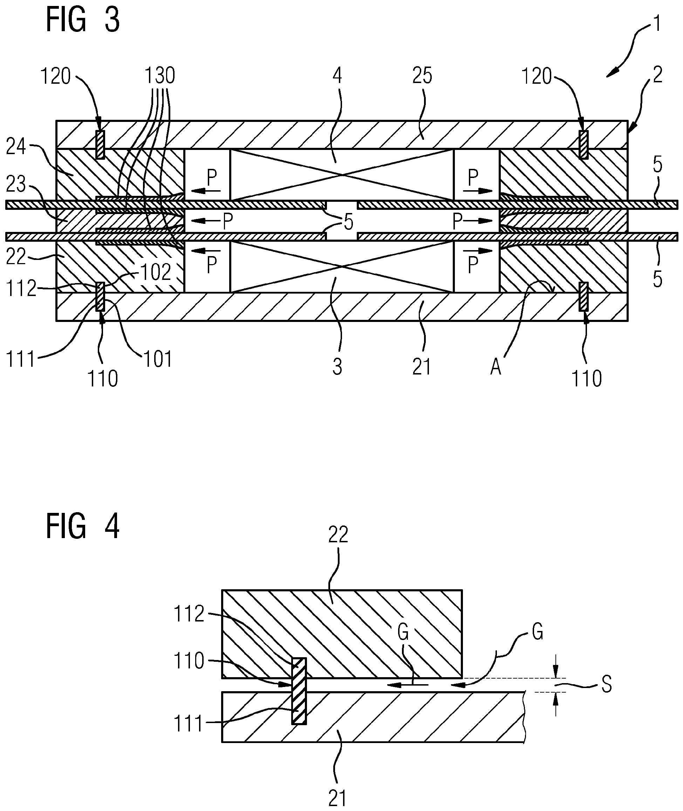

Die Figur 3 zeigt ein Ausführungsbeispiel für ein elektrisches Modul 1, das - im Wesentlichen - dem Aufbau des elektrischen Moduls 1 gemäß Figur 1 entspricht. So weist auch das elektrische Modul 1 gemäß Figur 3 eine untere Kühlplatte 21, drei ringförmige Rahmenelemente 22, 23 und 24 sowie eine obere Kühlplatte 25 auf, die das Modulgehäuse 2 nach außen hin abschließen und einen Innenraum 2a definieren, in dem zwei Halbleiterschaltelemente 3 und 4 untergebracht sind.

Um das im Zusammenhang mit der Figur 2 beschriebene Problem eines unerwünschten Gasstromes G durch einen Spalt S zwischen dem unteren ringförmigen Rahmenelement 22 und der unteren Kühlplatte 21 im Falle einer Explosion zu vermeiden (siehe auch Figur 4), ist bei dem elektrischen Modul 1 gemäß Figur 3 ein Dichtring 110 vorgesehen, der ringförmig um den Innenraum 2a des Modulgehäuses 2 umläuft.

Um die in der Figur 3 gezeigte Positionierung des Dichtrings 110 zu ermöglichen, weist die untere Kühlplatte 21 eine ringförmig um den Innenraum 2a umlaufende Vertiefung 101 auf, die - senkrecht zur Auflagefläche zwischen den beiden Gehäuseteilen 21 und 22 gesehen - mit einer ringförmig umlaufenden Vertiefung 102 im unteren ringförmigen Rahmenelement 22 fluchtet. Durch die zwei ringförmigen Vertiefungen 101 und 102, die auch als Nuten bezeichnet werden können, kann sich ein in der Figur 1 unterer Dichtabschnitt 111 des Dichtrings 110 senkrecht zur Auflageebene A, in der die beiden Gehäuseteile 21 und 22 aufeinanderliegen, in die Kühlplatte 21 hinein erstrecken. In entsprechender Weise kann sich ein in der Figur 3 oberer Dichtabschnitt 112 des Dichtrings 110 - senkrecht zur Auflagefläche bzw. Auflageebene A zwischen den beiden Gehäuseteilen 21 und 22 gesehen - in das darüber liegende untere ringförmige Rahmenelement 22 hinein erstrecken. Der Dichtring 110 weist somit Dichtflächen auf, die an senkrecht zur Auflageebene A liegenden Vertiefungswandabschnitten beider Gehäuseteile 21 und 22 anliegen.

Die Figur 4 zeigt die Wirkungsweise des Dichtrings 110 im Falle einer Explosion im Innenraum 2a des Modulgehäuses 2 und damit für den Fall, dass die beiden Modulgehäuseteile 21 und 22 durch den Gasdruck im Innenraum 2a auseinandergedrückt werden. Es lässt sich erkennen, dass zwischen den beiden Gehäuseteilen 21 und 22 ein Spalt S entsteht, jedoch kann dieser Spalt S zu keinem Gasstrom G nach außen führen, da der Gasfluss G durch den Dichtring 110 gestoppt wird, zumindest aber gehemmt oder reduziert wird. Diese Hemmung des Gasflusses G basiert darauf, dass sich die beiden Dichtabschnitte 111 und 112 winklig bzw. senkrecht zur Auflageebene A zwischen den beiden Gehäuseteilen 21 und 22 in die ringförmigen Vertiefungen 101 und 102 hineinerstrecken, so dass ein etwaig austretender Restgasstrom um das Dichtelement herumgelenkt werden muss.

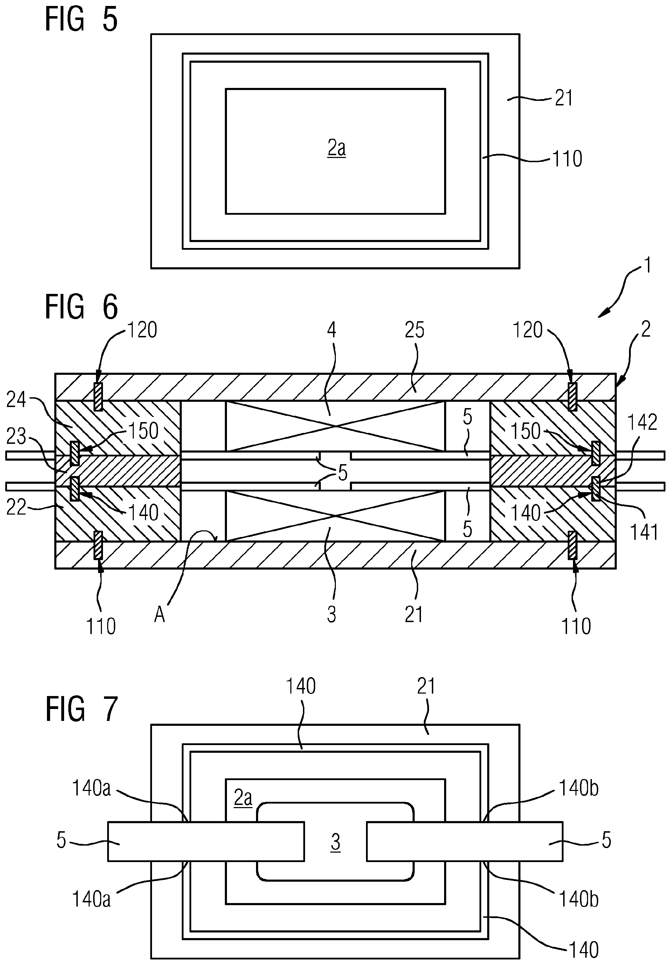

Die Figur 5 zeigt das ringförmige Umlaufen des Dichtrings 110 um den Innenraum 2a des Modulgehäuses 2 nochmals schematisch in einer Draufsicht.

Wieder bezugnehmend auf Figur 3 lässt sich in der Figur 3 darüber hinaus ein weiterer Dichtring 120 erkennen, der mit dem Dichtring 110 identisch sein kann. Der Dichtring 120 ist in ringförmig umlaufende Vertiefungen im oberen ringförmigen Rahmenelement 24 sowie in der oberen Kühlplatte 25 eingesetzt und dichtet die obere Kühlplatte 25 und das obere ringförmig umlaufende Rahmenelement 24 gegeneinander ab, und zwar in entsprechender Weise, wie dies im Zusammenhang mit dem Dichtring 110 erläutert worden ist.

Darüber hinaus erkennt man in der Figur 3 Plattendichtelemente 130, die zur Abdichtung zwischen den ringförmigen Rahmenelementen 22, 23 und 24 im Bereich der Kontaktschienen 5 dienen. Es lässt sich erkennen, dass die Plattendichtelemente 130 jeweils an einer zugeordneten Kontaktschiene 5 anliegen und sich in Richtung Innenraum 2a des Modulgehäuses 2 - senkrecht zur Auflageebene zwischen den jeweiligen Rahmenelementen - verdicken bzw. aufweiten. Die entsprechende Formgebung der Plattendichtelemente 130 wird durch eine korrespondierende bzw. komplementäre Formgebung von passenden Vertiefungen in den ringförmigen Rahmenelementen 22, 23 und 24 ermöglicht.

Durch das Aufweiten bzw. Verdicken der Plattendichtelemente 130 in Richtung des Innenraums 2a wird gewährleistet, dass der Gasdruck P im Innenraum 2a im Falle einer Explosion die verdickten Abschnitte der Plattendichtelemente 130 im Sinne einer Stopfen- bzw. Stöpselbildung weiter verdicken bzw. aufweiten wird, wodurch die Dichtwirkung der Plattendichtelemente 130 bei Erhöhung des Gasdrucks P innerhalb des Innenraums 2a in vorteilhafter Weise sogar vergrößert wird.

Die Figur 6 zeigt das elektrische Modul 1 bzw. dessen Modulgehäuse 2 gemäß den Figuren 3 bis 5 in einem anderen Querschnitt, nämlich in einem Querschnitt außerhalb des Bereichs der Kontaktschienen 5. Es lässt sich erkennen, dass außerhalb des Bereichs der Kontaktschienen 5 die drei ringförmigen Rahmenelemente 22, 23 und 24 unmittelbar aufeinanderliegen.

Um eine Abdichtung beispielsweise zwischen dem unteren ringförmigen Rahmenelement 22 und dem darüber befindlichen mittleren ringförmigen Rahmenelement 23 zu ermöglichen, sind zwischen diesen beiden Gehäuseteilen zwei halbringförmige Dichtelemente 140 vorgesehen, die jeweils mit einem in der Figur 6 unteren Dichtabschnitt 141 in das untere ringförmige Rahmenelement 22 hineinragen und mit einem in der Figur 6 oberen Dichtabschnitt 142 in eine korrespondierende Vertiefung im mittleren ringförmigen Rahmenelement 23 hineinragen.

Die Anordnung der halbringförmig umlaufenden Dichtelemente 140 ist in einer Draufsicht näher in der Figur 7 gezeigt. Es lässt sich erkennen, dass die zwei halbringförmigen Dichtelemente 140 einander gegenüberliegen, und zwar derart, dass ein erstes Dichtelementende 140a des einen Dichtelements 140 einem ersten Dichtelementende 140a des anderen Dichtelements 140 unter Bildung eines ersten Endenpaares gegenüberliegt und ein zweites Dichtelementende 140b des eines Dichtelements 140 einem zweiten Dichtelementende 140b des anderen Dichtelements 140 unter Bildung eines zweiten Endenpaares gegenüberliegt. Zwischen den paarweise gegenüberliegenden Dichtelementenden ist jeweils eine elektrische Kontaktschiene 5 angeordnet, die mit dem unteren Halbleiterschutzelement 3 elektrisch in Kontakt steht.

Zur Abdichtung zwischen dem mittleren ringförmigen Rahmenelement 23 und dem oberen ringförmigen Rahmenelement 24 sind halbringförmige Dichtelemente 150 vorgesehen, die in der Figur 6 gezeigt sind mit den halbringförmigen Dichtelementen 140 identisch sein können. Diesbezüglich sei auf die obigen Ausführungen verwiesen.

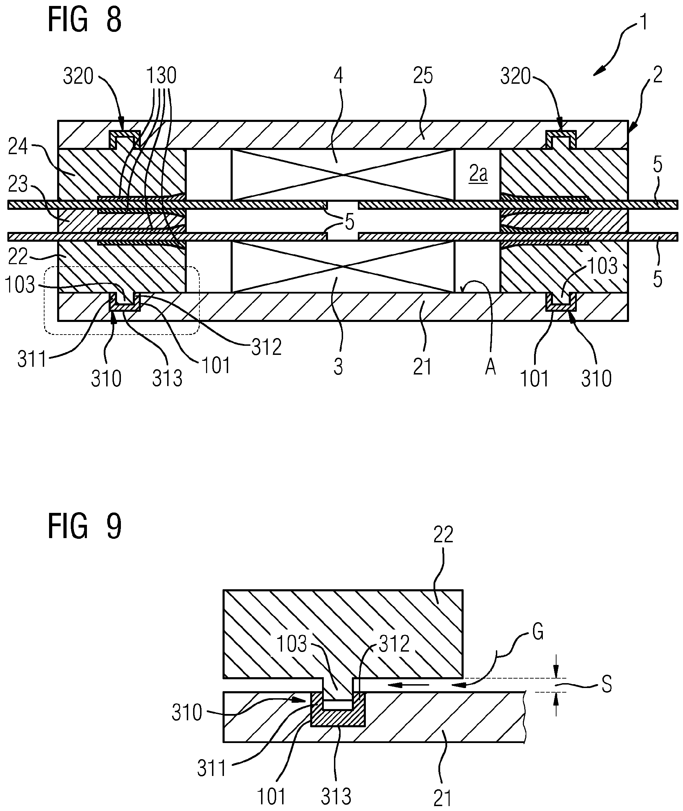

Die Figur 8 zeigt ein weiteres Ausführungsbeispiel für ein elektrisches Modul 1, bei dem zur Abdichtung von Modulgehäuseteilen Dichtelemente vorhanden sind.

Zur Abdichtung der in der Figur 8 unteren Kühlplatte 21 und dem darüber liegenden unteren ringförmigen Rahmenelement 22 ist bei dem Ausführungsbeispiel gemäß Figur 8 ein Dichtelement 310 vorgesehen, dass im Querschnitt u-förmig ist und ringförmig um den Innenraum 2a des Modulgehäuses 2 umläuft. Das Dichtelement 310 weist zwei Seitenwände 311 und 312 auf, die durch eine Bodenwand 313 verbunden sind. Jede der beiden Seitenwände 311 und 312 steht winklig zur Auflagefläche A bzw. zur Auflageebene, in der die beiden Gehäuseteile 21 und 22 aufeinanderliegen. Die Bodenwand 313 des Dichtelements 310 liegt vorzugsweise parallel zur Auflageebene bzw. Auflagefläche A.

Das im Querschnitt u-förmige Dichtelement 310 liegt in einer ringförmig umlaufenden Vertiefung 101 der unteren Kühlplatte 21. In die durch die beiden Seitenwände 311 und 312 des Dichtelements 310 definierte Innennut greift ein Vorsprung 103 des unteren ringförmigen Rahmenelements 22 ein; der Vorsprung 103 erstreckt sich winklig bzw. senkrecht zur Auflageebene A bzw. zur Auflagefläche zwischen den beiden Gehäuseteilen 21 und 22.

Durch das Eingreifen des Vorsprungs 103 in das u-förmige Dichtelement 310 wird eine Art Mäandrierung bzw. Mäanderbildung im Bereich der Schnittstelle bzw. Auflagefläche zwischen den Gehäuseteilen 21 und 22 erreicht, durch die im Falle einer Spaltbildung zwischen den Gehäuseteilen nach einer Explosion ein Gasstrom G mehrfach umgelenkt werden muss, bevor er nach außen gelangen kann; dies zeigt die Figur 9 näher im Detail. Es lässt sich erkennen, dass im Falle einer Bildung eines Spalts S ein Gasstrom G nicht parallel zur Auflagefläche A bzw. parallel zur Auflageebene nach außen gelangen kann, sondern zunächst durch den Vorsprung 103 und die nutförmige Vertiefung 101 insgesamt viermal umgelenkt wird, bevor er nach außen gelangen kann. Es erfolgt also eine Verlängerung des Gasweges und damit einhergehend eine signifikante Druck- und Temperaturreduktion des womöglich trotz des Dichtelementes 310 dennoch austretenden Restgasstromes.

Darüber hinaus lässt sich in der Figur 9 erkennen, dass der Gasstrom G außerdem durch das u-förmige Dichtelement 310 gestoppt wird, das zwischen Vertiefung 101 und Vorsprung 103 angeordnet ist.

Die Figur 8 zeigt darüber hinaus ein weiteres Dichtelement 320, das zwischen dem oberen ringförmigen Rahmenelement 24 und der oberen Kühlplatte 25 angeordnet ist und diese beiden Gehäuseteile in derselben Weise abdichtet, wie dies im Zusammenhang mit dem Dichtelement 310 erläutert worden ist.

Plattendichtelemente 130 dienen zum Abdichten des Modulgehäuses 2 im Bereich der Kontaktschienen 5; bezüglich der Ausgestaltung der Plattendichtelemente 130 sei auf die obigen Ausführungen im Zusammenhang mit dem Ausführungsbeispiel gemäß den Figuren 3 bis 7 verwiesen.

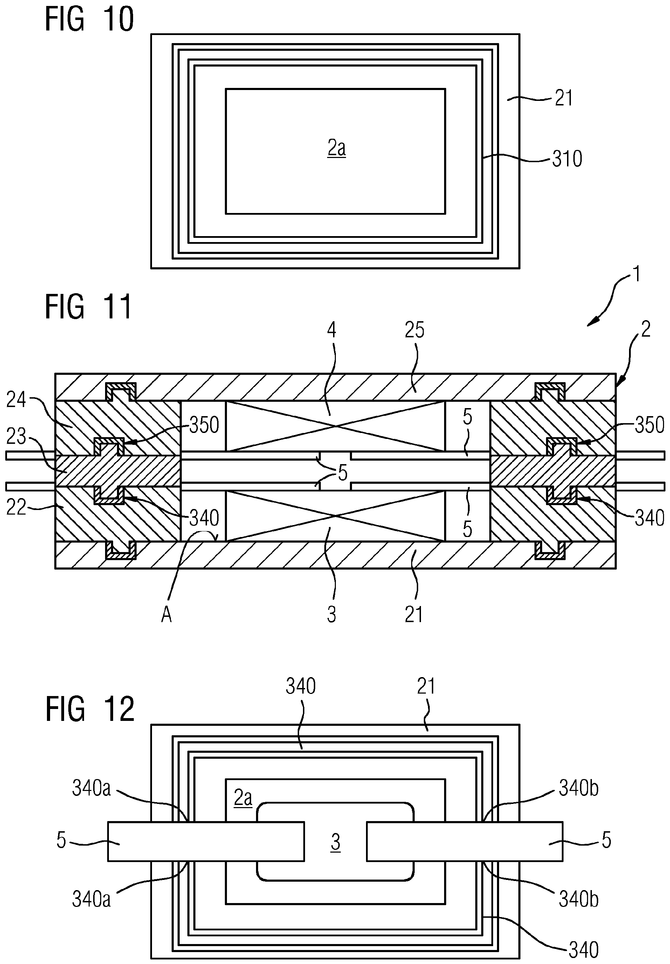

Die Figur 10 zeigt das Dichtelement 310 in einer Draufsicht. Es lässt sich erkennen, dass das das Dichtelement 310 ringförmig um den Innenraum 2a umläuft.

Die Figur 11 zeigt das elektrische Modul 1 gemäß den Figuren 8 bis 10 in einem anderen Querschnitt, und zwar in einem Bereich außerhalb der Kontaktschienen 5. Es lässt sich erkennen, dass im Bereich außerhalb der Kontaktschienen 5 eine Abdichtung der unmittelbar aufeinanderliegenden ringförmigen Rahmenelemente 22 und 23 durch ein halbringförmiges, im Querschnitt u-förmiges Dichtelement 340 erfolgt. Das Dichtelement 340 wird in einer Vertiefung im unteren ringförmigen Rahmenelement 22 durch einen korrespondierenden Vorsprung des darüber befindlichen ringförmigen Rahmenelements 23 eingeklemmt.

Die zur Abdichtung der beiden Rahmenelemente 22 und 23 vorgesehenen halbringförmigen Dichtelemente 340 sind in der Figur 12 näher in einer Draufsicht gezeigt. Es lässt sich erkennen, dass die Dichtelementenden 340a und 340b der Dichtelemente 340 jeweils paarweise gegenüberliegen und durch die Kontaktschienen 5 voneinander getrennt sind, mit denen die Kontaktierung des unteren Halbleiterschaltelements 3 erfolgt.

In der Figur 11 lässt sich darüber hinaus ein weiteres halbringförmiges Dichtelement 350 erkennen, das im Querschnitt u-förmig ist und zur Abdichtung des mittleren ringförmigen Rahmenelements 23 und des darüber befindlichen oberen ringförmigen Rahmenelements 24 geeignet ist. Die Dichtelemente 350 können mit den Dichtelementen 340 identisch sein, so dass diesbezüglich auf die obigen Ausführungen verwiesen sei.

Wie im Zusammenhang mit den Ausführungsbeispielen gemäß den Figuren 3 bis 12 erläutert wurde, können zur Abdichtung der beiden Kühlplatten 21 und 25 mit den daran anliegenden ringförmigen Rahmenelementen 22 bzw. 24 die Dichtringe 110 bzw. 120 gemäß den Figuren 3 bis 7 und/oder im Querschnitt u-förmige Dichtelemente 310 bzw. 320 gemäß den Figuren 8 bis 12 vorgesehen werden, die sich jeweils zumindest abschnittsweise in eines der abzudichtenden Gehäuseteile hinein erstrecken.

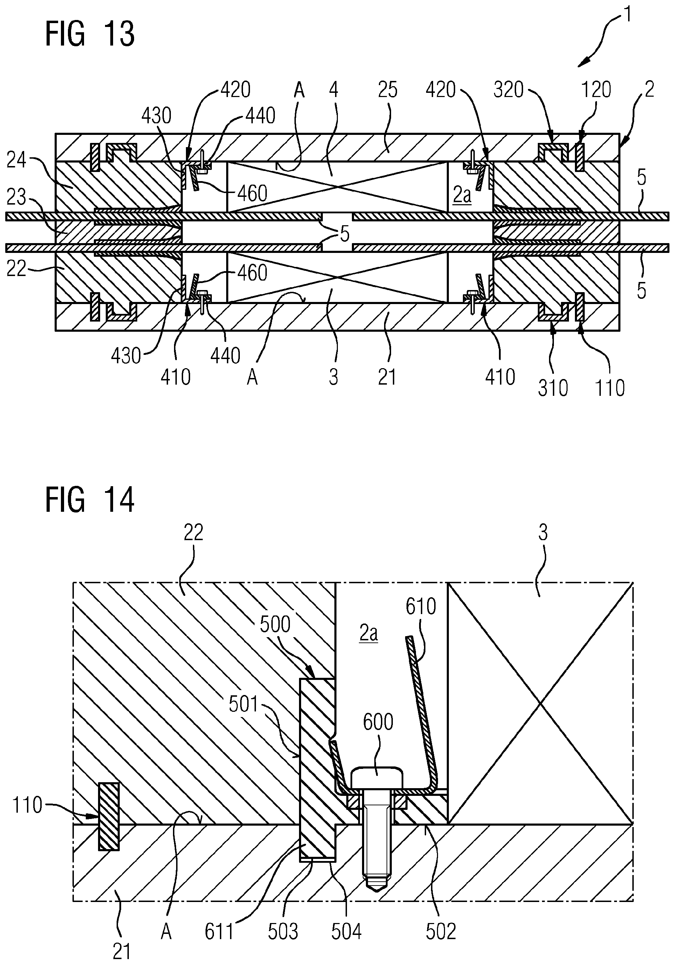

Alternativ oder zusätzlich kann vorgesehen sein, dass zur Abdichtung des Bereichs zwischen den Kühlplatten 21 und 25 und den daran anliegenden Rahmenelementen 22 und 24 ringförmig umlaufende Dichtelemente vorgesehen werden, die im Innenraum 2a angeordnet sind. Ein Ausführungsbeispiel für eine solche Variante ist in Figur 13 gezeigt.

In der Figur 13 sieht man im Querschnitt ringförmig umlaufende und im Querschnitt L-förmige Dichtelemente 410 und 420.

Die Dichtelemente 410 und 420 umfassen jeweils einen Dichtabschnitt 430, der winklig, insbesondere rechtwinklig, zur jeweiligen Auflageebene bzw. Auflagefläche A der abzudichtenden Gehäuseteile liegt und jeweils einen weiteren Dichtabschnitt 440, der parallel bzw. in der Auflageebene A liegt. Zum Schutz der Dichtelemente 410 und 420 vor einem Partikelbeschuss im Falle einer Explosion der Halbleiterschaltelemente 3 oder 4 bzw. beider Schaltelemente 3 und 4 sind Schutzelemente 460 vorgesehen, die die Dichtelemente 410 und 420 vor Zerstörung schützen.

In der Figur 14 ist ein weiteres Ausführungsbeispiel für eine vorteilhafte Abdichtung für den Bereich zwischen den Kühlplatten 21 und 25 und den daran anliegenden Rahmenelementen 22 und 24 gezeigt. Man erkennt im Bereich der Auflageebene A zwischen der Kühlplatte 21 und dem Rahmenelement 22 ein ringförmig umlaufendes Dichtelement 500, das mit einer senkrecht zur Auflageebene A angeordneten Dichtfläche 501 an dem Rahmenelement 22 anliegt, mit einer parallel zur Auflageebene A angeordneten Dichtfläche 502 auf der Kühlplatte 21 aufliegt und mit einer Dichtlippe 503 in eine Nut 504 in der Kühlplatte 21 eingreift. Das Dichtelement 500 wird von einer Schraube 600 und einer Manschette 610 gehalten. Die Manschette 610, insbesondere ein innenliegender Abschnitt 611 der Manschette 610, drückt im Falle einer Explosion im Innenraum 2a das Dichtelement 600 gegen die Kühlpatte 21 und gegen das Rahmenelement 22 und verbessert somit die Abdichtwirkung.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 1: Modul
- 2: Modulgehäuse
- 2a: Innenraum
- 3: unteres Halbleiterschaltelement
- 4: oberes Halbleiterschaltelement
- 5: Kontaktschienen
- 21: untere Kühlplatte
- 22: unteres ringförmiges Rahmenelement
- 23: mittleres ringförmiges Rahmenelement
- 24: oberes ringförmiges Rahmenelement
- 25: obere Kühlplatte
- 101: Vertiefung
- 102: Vertiefung
- 103: Vorsprung
- 110: Dichtring
- 111: unterer Dichtabschnitt
- 112: oberer Dichtabschnitt
- 120: Dichtring
- 130: Plattendichtelemente
- 140: halbringförmige Dichtelemente
- 140a: Dichtelementende
- 140b: Dichtelementende
- 141: unterer Dichtabschnitt
- 142: oberer Dichtabschnitt
- 150: Dichtelemente
- 200a: Innenraum
- 310: Dichtelement
- 311: Seitenwand
- 312: Seitenwand
- 313: Bodenwand
- 320: Dichtelement
- 340: Dichtelement
- 340a: Dichtelementende
- 340b: Dichtelementende
- 350: Dichtelement
- 410: Dichtelement
- 420: Dichtelement
- 430: Dichtabschnitt
- 440: Dichtabschnitt
- 460: Schutzelemente
- 500: Dichtelement
- 501: Dichtfläche
- 502: Dichtfläche
- 503: Dichtlippe
- 504: Nut
- 600: Schraube
- 610: Manschette
- 611: innenliegender Abschnitt

- A: Auflagefläche/Auflageebene
- F: Pfeile
- G: Gasstrom
- P: Gasdruck
- S: Spalt

## Patentansprüche

1. Elektrisches Modul (1) für einen Umrichter mit zumindest einem in einem Modulgehäuse (2) untergebrachten Halbleiterschaltelement (3), insbesondere ein Bipolartransistor mit isolierter Gateelektrode, wobei
- das Modulgehäuse (2) zumindest zwei Gehäuseteile (21-25) aufweist, die aufeinander liegen und - allein oder gemeinsam mit einem oder mehreren weiteren Gehäuseteilen (21-25) des Modulgehäuses (2) - den Innenraum (2a) des Modulgehäuses (2) begrenzen, und
- zur Abdichtung der Auflagefläche zwischen den beiden Gehäuseteilen (21-25) mindestens ein Dichtelement (110, 120, 140, 150, 310, 320, 340, 350, 410, 420, 500) vorhanden ist,
**dadurch gekennzeichnet, dass**
- die zwei Gehäuseteile (21-25) jeweils eine Vertiefunq (101, 102), insbesondere Nut, aufweisen und
- das Dichtelement (110, 120, 140, 150, 310, 320, 340, 350, 410, 420, 500) mit einem Dichtabschnitt in die Vertiefung (101, 102) in dem einen Gehäuseteil (21-25) und mit einem anderen Dichtabschnitt in die Vertiefung (101, 102) in dem anderen Gehäuseteil (21-25) hineinragt, so dass im Falle einer Explosion im Innenraum (2a) des Modulgehäuses (2) ein Austreten von Explosionsgasen nach außen durch das Dichtelement (110, 120, 140, 150, 310, 320, 340, 350, 410, 420, 500) gestoppt oder zumindest reduziert wird.

2. Modul (1) nach Anspruch 1,
**dadurch gekennzeichnet, dass**
das Dichtelement oder zumindest ein Dichtabschnitt des Dichtelements, insbesondere eine Dichtlippe des Dichtelements, sich winklig zu derjenigen Auflageebene (A) erstreckt, in der die zwei Gehäuseteile (21-25) aufeinander liegen.

3. Modul (1) nach einem der voranstehenden Ansprüche,
**dadurch gekennzeichnet, dass**
zumindest eines der zwei Gehäuseteile (21-25) eine Vertiefung (101, 102), insbesondere Nut, aufweist, in die das Dichtelement oder ein Dichtabschnitt hineinragt oder in der sich das Dichtelement oder der Dichtabschnitt befindet.

4. Modul (1) nach einem der voranstehenden Ansprüche,
**dadurch gekennzeichnet, dass**
die Vertiefungen (101, 102) übereinanderliegen oder - senkrecht zur Auflagefläche zwischen den beiden Gehäuseteilen (21-25) gesehen - fluchten.

5. Modul (1) nach einem der voranstehenden Ansprüche,
**dadurch gekennzeichnet, dass**
das Dichtelement mindestens eine Dichtfläche aufweist, die an einem schräg, insbesondere senkrecht, zur Auflageebene (A) erstreckenden Vertiefungswandabschnitt des einen oder anderen der beiden Gehäuseteile (21-25) oder an schräg, insbesondere senkrecht, zur Auflageebene (A) erstreckenden Vertiefungswandabschnitten beider Gehäuseteile (21-25) anliegt.

6. Modul (1) nach einem der voranstehenden Ansprüche,
**dadurch gekennzeichnet, dass**
- eines der zwei Gehäuseteile (21-25) eine Vertiefung (101, 102), insbesondere Nut, aufweist, in die ein Vorsprung (103) des anderen Gehäuseteils (21-25), eingreift und
- in die Vertiefung (101, 102), zwischen Vertiefungswand und Vorsprung (103), das Dichtelement eingelegt ist.

7. Modul (1) nach Anspruch 6,
**dadurch gekennzeichnet, dass**
- das Dichtelement im Querschnitt u-förmig oder zumindest abschnittsweise u-förmig ist und zwei Seitenwände (311, 312) und eine die beiden Seitenwände (311, 312) verbindende Bodenwand (313) aufweist,
- jede der beiden Seitenwände (311, 312) jeweils einen Dichtabschnitt bildet, der winklig zur Auflageebene (A), in der die zwei Gehäuseteile (21-25) aufeinander liegen, angeordnet ist und
- die Bodenwand (313) des Dichtelements auf dem, insbesondere parallel zur Auflageebene (A) liegenden, Vertiefungsboden, insbesondere Nutboden, aufliegt.

8. Modul (1) nach einem der voranstehenden Ansprüche,
**dadurch gekennzeichnet, dass**
- die Vertiefung (101, 102) ringförmig ist und ringförmig um den Innenraum (2a) des Modulgehäuses (2) außen herumläuft, und
- das Dichtelement durch einen Dichtring gebildet ist, der den Innenraum (2a) des Modulgehäuses (2) ringförmig außen abdichtet.

9. Modul (1) nach einem der voranstehenden Ansprüche 1 bis 7,
**dadurch gekennzeichnet, dass**
- die Vertiefung halbringförmig oder wegen durchgeführter elektrischer Kontakte nur annähernd halbringförmig, ist und um die Hälfte des Innenraums (2a) des Modulgehäuses (2) oder nahezu die Hälfte außen herumläuft, und
- das Dichtelement halbringförmig oder annähernd halbringförmig, ist.

10. Modul (1) nach Anspruch 9,
**dadurch gekennzeichnet, dass**
- eines der zwei Gehäuseteile (21-25), oder jeweils beide, zwei halbringförmig umlaufende Nuten aufweist, in die jeweils ein halbringförmiges Dichtelement (140, 340) eingelegt ist,
- ein erstes Dichtelementende (140a, 340a) des einen Dichtelements (140, 340) einem ersten Dichtelementende (140a, 340a) des anderen Dichtelements (140, 340) unter Bildung eines ersten Endenpaares gegenüberliegt und ein zweites Dichtelementende (140b, 340b) des einen Dichtelements (140, 340) einem zweiten Dichtelementende (140b, 340b) des anderen Dichtelements (140, 340) unter Bildung eines zweiten Endenpaares gegenüberliegt und
- zwischen den paarweise gegenüber liegenden Dichtelementenden jeweils eine elektrische Kontaktschiene (5) angeordnet ist, die mit der zumindest einen in dem Modulgehäuse (2) untergebrachten elektrischen Komponente elektrisch verbunden ist.

11. Modul (1) nach einem der voranstehenden Ansprüche,
**dadurch gekennzeichnet, dass**
unter und über den Kontaktschienen (5) jeweils ein Plattendichtelement aufliegt, das sich in Richtung Innenraum (2a) des Modulgehäuses (2) - senkrecht zur Auflageebene (A) - verdickt oder aufweitet.

12. Modul (1) nach einem der voranstehenden Ansprüche,
**dadurch gekennzeichnet, dass**
- an der Schnittstellenkante zwischen den zwei Gehäuseteilen (21-25) innenraumseitig ein ringförmig umlaufendes Dichtelement angeordnet ist, das flächig an den beiden Gehäuseteilen (21-25) anliegt und bei dem sich ein Dichtabschnitt oder eine Dichtfläche winklig, insbesondere rechtwinklig, zur Auflageebene (A) erstreckt und ein anderer Dichtabschnitt oder eine andere Dichtfläche in der Auflageebene (A) liegt,
- wobei vorzugsweise ein vor dem Dichtelement angeordnetes oder in dem Dichtelement integriertes Schutzelement das Dichtelement vor einer Zerstörung durch Partikelbeschuss im Falle eines explosionsartiges Ausfalls der in dem Modulgehäuse (2) untergebrachten elektrischen Komponente schützt.

13. Modul (1) nach einem der voranstehenden Ansprüche,
**dadurch gekennzeichnet, dass**
- eines der zwei Gehäuseteile (21-25) eine die elektrische Komponente tragende Kühlplatte bildet und das andere der zwei Gehäuseteile (21-25) ein ringförmiges Rahmenelement ist oder
- beide Gehäuseteile (21-25) jeweils ringförmige Rahmenelemente sind.

14. Modul (1) nach einem der voranstehenden Ansprüche,
**dadurch gekennzeichnet, dass**
das Modulgehäuse (2) folgende Modulgehäuseteile umfasst:
- eine untere Kühlplatte (21), die eine untere elektrische Komponente, vorzugsweise ein Halbleiterschaltelement (3), insbesondere ein einen Transistor aufweisendes Halbleiterschaltelement, trägt,
- ein unteres ringförmiges Rahmenelement (22), das auf der unteren Kühlplatte (21) aufliegt,
- ein mittleres ringförmiges Rahmenelement (23), das auf dem unteren Rahmenelement (22) aufliegt, wobei zwischen dem unteren und dem mittleren ringförmigen Rahmenelement zumindest zwei Kontaktschienen (5) zur Kontaktierung der unteren elektrischen Komponente aus dem Modulgehäuse (2) herausgeführt sind,
- ein oberes ringförmiges Rahmenelement (24), das auf dem mittleren ringförmigen Rahmenelement (23) aufliegt, wobei zwischen dem mittleren und dem oberen ringförmigen Rahmenelement zumindest zwei Kontaktschienen (5) zur Kontaktierung einer oberen elektrischen Komponente, vorzugsweise eines Halbleiterschaltelements (4), insbesondere eines einen Transistor aufweisenden Halbleiterschaltelements, aus dem Modulgehäuse (2) herausgeführt sind, und
- eine obere Kühlplatte (25), die auf dem oberen ringförmigen Rahmenelement (24) aufliegt und die oberen elektrische Komponente trägt,
wobei die beiden oben genannten, mittels des mindestens einen Dichtelements abgedichteten Gehäuseteile (21-25) zwei der genannten Modulgehäuseteile bilden, die unmittelbar aufeinander liegen.

## Claims

1. Electrical module (1) for a converter, having at least one semiconductor switching element (3) which is accommodated in a module housing (2), in particular a bipolar transistor with an insulated gate electrode, wherein
- the module housing (2) has at least two housing parts (21-25) which lie one on the other and - on their own or together with one or more further housing parts (21-25) of the module housing (2) - delimit the interior (2a) of the module housing (2), and
- there is at least one sealing element (110, 120, 140, 150, 310, 320, 340, 350, 410, 420, 500) for sealing off the bearing surface between the two housing parts (21-25),
**characterized in that**
- the two housing parts (21-25) each have a recess (101, 102), in particular groove, and
- the sealing element (110, 120, 140, 150, 310, 320, 340, 350, 410, 420, 500) protrudes by way of a sealing section into the recess (101, 102) in one housing part (21-25) and by way of another sealing section into the recess (101, 102) in the other housing part (21-25), so that, in the event of an explosion in the interior (2a) of the module housing (2), escape of explosion gases to the outside through the sealing element (110, 120, 140, 150, 310, 320, 340, 350, 410, 420, 500) is stopped or at least reduced.

2. Module (1) according to Claim 1,
**characterized in that**
the sealing element or at least one sealing section of the sealing element, in particular a sealing lip of the sealing element, extends at an angle in relation to that bearing plane (A) in which the two housing parts (21-25) lie one on the other.

3. Module (1) according to either of the preceding claims,
**characterized in that**
at least one of the two housing parts (21-25) has a recess (101, 102), in particular groove, into which the sealing element or a sealing section protrudes or in which the sealing element or the sealing section is located.

4. Module (1) according to one of the preceding claims,
**characterized in that**
the recesses (101, 102) lie one above the other or - as seen perpendicularly in relation to the bearing surface between the two housing parts (21-25) - are in alignment.

5. Module (1) according to one of the preceding claims,
**characterized in that**
the sealing element has at least one sealing surface which bears against a recess wall section of one or other of the two housing parts (21-25), which recess wall section extends obliquely, in particular perpendicularly, in relation to the bearing plane (A), or against recess wall sections of both housing parts (21-25), which recess wall sections extend obliquely, in particular perpendicularly, in relation to the bearing plane (A).

6. Module (1) according to one of the preceding claims,
**characterized in that**
- one of the two housing parts (21-25) has a recess (101, 102), in particular groove, into which a projection (103) of the other housing part (21-25) engages, and
- a sealing element is inserted into the recess (101, 102), between the recess wall and the projection (103).

7. Module (1) according to Claim 6,
**characterized in that**
- the sealing element is u-shaped in cross section or u-shaped at least in sections and has two side walls (311, 312) and one base wall (313) which connects the two side walls (311, 312),
- each of the two side walls (311, 312) respectively forms a sealing section which is arranged at an angle in relation to the bearing plane (A) in which the two housing parts (21-25) lie one on the other, and
- the base wall (313) of the sealing element rests on the recess base, in particular groove base, in particular which lies parallel in relation to the bearing plane (A).

8. Module (1) according to one of the preceding claims, **characterized in that**
- the recess (101, 102) is annular and runs in an annular manner around the interior (2a) of the module housing (2) on the outside, and
- the sealing element is formed by a sealing ring which seals off the interior (2a) of the module housing (2) in an annular manner on the outside.

9. Module (1) according to one of the preceding Claims 1 to 7,
**characterized in that**
- the recess is in the form of a half-ring or only approximately in the form of a half-ring owing to the electrical contacts being passed through and runs around half of the interior (2a) of the module housing (2) or virtually half on the outside, and
- the sealing element is in the form of a half-ring or approximately in the form of a half-ring.

10. Module (1) according to Claim 9,
**characterized in that**
- one of the two housing parts (21-25) or in each case both housing parts has/have two grooves which encircle in the form of a half-ring and into each of which a sealing element (140, 340) in the form of a half-ring is inserted,
- a first sealing element end (140a, 340a) of one sealing element (140, 340) is situated opposite a first sealing element end (140a, 340a) of the other sealing element (140, 340) so as to form a first pair of ends, and a second sealing element end (140b, 340b) of one sealing element (140, 340) is situated opposite a second sealing element end (140b, 340b) of the other sealing element (140, 340) so as to form a second pair of ends, and
- a respective electrical contact rail (5) is arranged between the sealing element ends which are situated opposite one another in pairs, which contact rail is electrically connected to the at least one electrical component which is accommodated in the module housing (2).

11. Module (1) according to one of the preceding claims,
**characterized in that**
in each case one plate sealing element rests below and above the contact rails (5), which plate sealing element - perpendicularly in relation to the bearing plane (A) - becomes thicker or wider in the direction of the interior (2a) of the module housing (2).

12. Module (1) according to one of the preceding claims,
**characterized in that**
- an annularly encircling sealing element is arranged on the interior side of the interface edge between the two housing parts (21-25), which sealing element bears in a planar manner against the two housing parts (21-25), and in which sealing element a sealing section or a sealing surface extends in an angular manner, in particular in a rectangular manner, in relation to the bearing plane (A), and another sealing section or another sealing surface lies in the bearing plane (A),
- wherein preferably a protective element which is arranged in front of the sealing element or is integrated in the sealing element protects the sealing element against destruction by particle bombardment in the event of an explosion-like breakdown of the electrical component which is accommodated in the module housing (2).

13. Module (1) according to one of the preceding claims,
**characterized in that**
- one of the two housing parts (21-25) forms a cooling plate which supports the electrical component, and the other of the two housing parts (21-25) is an annular frame element or
- the two housing parts (21-25) are each annular frame elements.

14. Module (1) according to one of the preceding claims,
**characterized in that**
the module housing (2) comprises the following module housing parts:
- a lower cooling plate (21) which supports a lower electrical component, preferably a semiconductor switching element (3), in particular a semiconductor switching element which has a transistor,
- a lower annular frame element (22) which rests on the lower cooling plate (21),
- a central annular frame element (23) which rests on the lower frame element (22), wherein at least two contact rails (5) for making contact with the lower electrical component are guided out of the module housing (2) between the lower and the central annular frame element,
- an upper annular frame element (24) which rests on the central annular frame element (23), wherein at least two contact rails (5) for making contact with an upper electrical component, preferably a semiconductor switching element (4), in particular a semiconductor switching element having a transistor, are guided out of the module housing (2) between the central and the upper annular frame element, and
- an upper cooling plate (25) which rests on the upper annular frame element (24) and supports the upper electrical component,
wherein the two abovementioned housing parts (21-25) which are sealed off by means of the at least one sealing element form two of the said module housing parts which lie directly one on the other.

## Revendications

1. Module (1) électrique d'un convertisseur, comprenant au moins un élément (3) de coupure à semi-conducteur logé dans un boîtier (2) de module, notamment un transistor bipolaire à électrode de grille isolée, dans lequel
- le boîtier (2) du module a au moins deux parties (21 à 25) de boîtier, qui sont disposées l'une sur l'autre et - seules ou conjointement avec une ou plusieurs autres parties (21 à 25) du boîtier (2) du module - délimitent l'espace (2a) intérieur du boîtier (2) du module, et
- pour rendre étanche la surface d'application entre les deux parties (21 à 25) du boîtier, il y a au moins un élément (110, 120, 140, 150, 310, 320, 340, 350, 410, 420, 500) d'étanchéité,
**caractérisé en ce que**
- les deux parties (21 à 25) du boîtier ont chacune un creux (101, 102), notamment une rainure, et
- l'élément (110, 120, 140, 150, 310, 320, 340, 350, 410, 420, 500) d'étanchéité pénètre par une partie d'étanchéité dans le creux (101, 102) de l'une des parties (21 à 25) du boîtier et par une autre partie d'étanchéité dans le creux (101, 102) de l'autre partie (21 à 25) du boîtier, de manière à ce que, dans le cas d'une explosion dans l'espace (2a) intérieur du boîtier (2) du module, une sortie de gaz d'explosion vers l'extérieur soit empêchée ou au moins réduite par l'élément (110, 120, 140, 150, 310, 320, 340, 350, 410, 420, 500) d'étanchéité.

2. Module (1) suivant la revendication 1,
**caractérisé en ce que**
l'élément d'étanchéité ou au moins une partie d'étanchéité de l'élément d'étanchéité, notamment une lèvre d'étanchéité de l'élément d'étanchéité, s'étend en faisant un angle avec le plan (A) d'application, dans lequel les deux parties (21 à 25) du boîtier s'appliquent l'une à l'autre.

3. Module (1) suivant l'une des revendications précédentes,
**caractérisé en ce qu'**
au moins l'une des deux parties (21 à 25) du boîtier a un creux (101, 102), notamment une rainure, dans lequel pénètre l'élément d'étanchéité ou une partie d'étanchéité, ou dans lequel se trouve l'élément d'étanchéité ou la partie d'étanchéité.

4. Module (1) suivant l'une des revendications précédentes,
**caractérisé en ce que** les creux (101, 102) sont superposés ou - considéré perpendiculairement à la surface d'application entre les deux parties (21 à 25) du boîtier - sont alignés.

5. Module (1) suivant l'une des revendications précédente,
**caractérisé en ce que**
l'élément d'étanchéité a au moins une surface d'étanchéité, qui s'applique à une partie de paroi du creux, s'étendant de manière inclinée par rapport au plan (A) d'application, en y étant notamment perpendiculaire, de l'une ou de l'autre des deux parties (21 à 25) du boîtier ou qui s'applique par des parties de paroi de creux, s'étendant de manière inclinée par rapport au plan (A) d'application, en y étant notamment perpendiculaire, des deux parties (21 à 25) du boîtier.

6. Module (1) suivant l'une des revendications précédentes,
**caractérisé en ce que**
- l'une des deux parties (21 à 25) du boîtier a un creux (101, 102), notamment une rainure, dans laquelle pénètre une saillie (103) de l'autre partie (21 à 25) du boîtier et
- l'élément d'étanchéité est mis dans le creux (101, 102) entre la paroi du creux et la saillie (103).

7. Module (1) suivant la revendication 6,
**caractérisé en ce que**
- l'élément d'étanchéité a en section transversale une forme en u ou est en forme en u au moins par endroit et a deux parois (311, 312) latérales et une paroi (313) de fond reliant les deux parois (311, 312) latérales,
- chacune des deux parois (311, 312) latérales forme, respectivement, une partie d'étanchéité, qui est disposée en faisant un angle avec le plan (A) d'application, dans lequel les deux parties (21 à 25) du boîtier sont superposées, et
- la paroi (313) de fond de l'élément d'étanchéité s'applique au fond du creux, notamment au fond de la rainure, se trouvant notamment parallèlement au plan (A) d'application.

8. Module (1) suivant l'une des revendications précédentes,
**caractérisé en ce que**
- le creux (101, 102) est annulaire et tourne annulairement autour de l'espace (2a) intérieur du boîtier (2) du module, et
- l'élément d'étanchéité est formé d'une bague d'étanchéité, qui rend étanche annulairement, vis-à-vis de l'extérieur, l'espace (2a) intérieur du boîtier (2) du module.

9. Module (1) suivant l'une des revendications 1 à 7,
**caractérisé en ce que**
- le creux est en forme de demi anneau ou, en raison du passage de contacts électriques, n'est qu'à peu près en demi anneau et tourne à l'extérieur autour de la moitié de l'espace (2a) intérieur du boîtier (2) du module ou de presque la moitié, et
- l'élément d'étanchéité est en forme de demi anneau ou à peu près en forme de demi anneau.

10. Module (1) suivant la revendication 9,
**caractérisé en ce que**
- l'une des deux parties (21 à 25) du boîtier, ou respectivement les deux, a deux rainures faisant le tour en forme de demi anneau, dans lesquelles est inséré, respectivement, un élément (140, 340) d'étanchéité en forme de demi anneau,
- une première extrémité (140a, 340a) de l'élément (140, 340) d'étanchéité est opposée à une première extrémité (140a, 340a) de l'autre élément (140, 340) d'étanchéité avec formation d'une première paire d'extrémités, et une deuxième extrémité (140b, 340b) du un élément (140, 340) d'étanchéité est opposée à une deuxième extrémité (140b, 340b) de l'autre élément (140, 340) d'étanchéité avec formation d'une deuxième paire d'extrémités et
- entre les extrémités d'éléments d'étanchéité opposées paire par paire est disposée, respectivement, une barre (5) de contact électrique, qui est reliée électriquement au au moins un composant électrique logé dans le boîtier (2) du module.

11. Module (1) suivant l'une des revendications précédentes,
**caractérisé en ce qu'**
en dessous et au dessus de la barre (5) de contact, s'applique, respectivement, un élément d'étanchéité en forme de plaque, qui s'épaissit ou s'élargit - perpendiculairement au plan (A) d'application - dans la direction de l'espace (2a) intérieur du boîtier (2) du module.

12. Module (1) suivant l'une des revendications précédentes,
**caractérisé en ce que**
- au bord d'interface entre les deux parties (21 à 25) du boîtier est disposé, du côté de l'espace intérieur, un élément d'étanchéité faisant le tour en forme de bague, qui s'applique, par une surface, sur les deux parties (21 à 25) du boîtier et dans lequel une partie d'étanchéité ou une surface d'étanchéité s'étend en faisant un angle, notamment un angle droit, avec le plan (A) d'application et une autre partie d'étanchéité ou une autre surface d'étanchéité est dans le plan (A) d'application,
- dans lequel de préférence un élément de protection, disposé avant l'élément d'étanchéité ou intégré à l'élément d'étanchéité, protège l'élément d'étanchéité d'une destruction par choc de particules, dans le cas d'une défaillance de type par explosion, des composants électriques logés dans le boîtier (2) du module.

13. Module (1) suivant l'une de revendications précédentes,
**caractérisé en ce que**
- l'une des deux parties (21 à 25) du boîtier forme une plaque de refroidissement portant les composant électriques et l'autre des deux parties (21 à 25) du boîtier est un élément de cadre de forme annulaire ou
- les deux parties (21 à 25) du boîtier sont chacune des éléments de cadre de forme annulaire.

14. Module (1) suivant l'une des revendications précédentes,
**caractérisé en ce que**
le boîtier (2) du module comprend les parties suivantes :
- une plaque (21) inférieure de refroidissement, qui porte un composant électrique inférieur, de préférence un élément (3) de coupure à semi-conducteur, notamment un élément de coupure à semi-conducteur ayant un transistor,
- un élément (22) inférieur de cadre annulaire, qui s'applique à la plaque (21) inférieure de refroidissement,
- un élément (23) de cadre intermédiaire annulaire, qui s'applique à l'élément (22) inférieur de cadre, au moins deux barres (5) de contact pour la mise en contact des composants électriques inférieurs étant sorties du boîtier (2) du module entre l'élément de cadre annulaire inférieur et l'élément de cadre annulaire intermédiaire,
- un élément (24) de cadre annulaire supérieur, qui s'applique à l'élément (23) de cadre intermédiaire annulaire, au moins deux barres (5) de contact pour la mise en contact d'un composant électrique supérieur, de préférence d'un élément (4) de coupure à semi-conducteur, notamment d'un élément de coupure à semi-conducteur ayant un transistor, étant sorties du boîtier (2) du module entre l'élément de cadre annulaire intermédiaire et l'élément de cadre annulaire supérieur, et
- une plaque (25) supérieure de refroidissement, qui s'applique à l'élément (24) de cadre annulaire supérieur et qui porte les composants électriques supérieurs,
dans lequel les deux parties (21 à 25) du boîtier ou les parties (21 à 25) du boîtier mentionnées, rendues étanches au moyen du au moins un élément d'étanchéité, forment deux des parties mentionnées du boîtier du module, qui sont directement l'une sur l'autre.
